# EUROPEAN PATENT SPECIFICATION

(11) **EP 3 390 227 B1**
(45) Date of publication and mention of the grant of the patent: **20.05.2020**
(21) Application number: 16867412.5
(22) Date of filing: 12.12.2016
(51) Int. Cl.: H04B 7/185, G05D 1/00, B64C 39/02, B64D 47/08, G01C 17/02, G01C 5/06, H01Q 1/28

(54) **USER INTERFACE FOR ORIENTING ANTENNAS**
BENUTZERSCHNITTSTELLE ZUR AUSRICHTUNG VON ANTENNEN
INTERFACE UTILISATEUR POUR L'ORIENTATION D'ANTENNES

(30) Priority: 14.12.2015 US 201562267176 P; 08.12.2016 US 201615373361
(43) Date of publication of application: 24.10.2018
(73) Proprietor: GoPro, Inc., San Mateo, CA 94402 (US)
(72) Inventor: FLANIGAN, Sean, Michael, San Mateo, CA 94402 (US); ENKE, Joseph, Anthony, San Mateo, CA 94402 (US); COOKE, Adrian, Matthew, San Mateo, CA 94402 (US); SPALL, John, Michael, San Mateo, CA 94402 (US)
(74) Representative: Richardson, Mark Jonathan
(86) International application number: PCT/US2016/066148
(87) International publication number: WO 2017/106094

(56) References cited:
- EP-A1- 2 131 443
- EP-A1- 3 086 195
- US-A1- 2010 084 513
- US-A1- 2012 089 274

## Description

### RELATED APPLICATIONS

This application claims the benefit of U.S. Provisional Patent Application No. 62/267, 176, filed on December 14, 2015, and U.S. Patent Application No. 15/373,361, filed on December 8, 2016.

### BACKGROUND

### FIELD OF ART

The disclosure generally relates to the field of remote controllers for remote controlled vehicle, e.g., unmanned aerial vehicles, and in particular to a directional antenna in a remote controller.

### DESCRIPTION OF ART

Remote controlled or unmanned aerial vehicles, such as quadcopters, are known. Aerial vehicles continue to grow in popularity for both their commercial applications as well as recreational uses by hobbyists.

The ability of remote controlled aerial vehicles to quickly traverse space and to access places which a user cannot provides for many useful applications. However, a remote controlled aerial vehicle must, in general, maintain communicative contact with a remote controller, held by the user. Loss of connection between a remote controlled aerial vehicle and its remote controller can be potentially catastrophic. Without user control, a remote controlled aerial vehicle may crash or may otherwise be lost. Thus, the utility of the aerial vehicle is restricted by the effective communication range of the receivers and transmitters in the remote controller and aerial vehicle.

The effective communication range of the aerial vehicle may be extended by increasing the transmit power of the antennas used for communication. However, a communication system with high transmit power may require more expensive communication electronics and cause significant battery drain. Furthermore, maximum radiated power is often limited by government regulations.

EP 2131443 describes a system and method for communication with an autonomous air vehicle, the system comprising a steerable antenna array including a plurality of directional antenna elements each selectable to receive a video signal from the air vehicle.

Hence, there is a need to resolve these issues by extending the communication range of the aerial vehicle and remote controller.

### BRIEF DESCRIPTION OF THE DRAWINGS

The disclosed embodiments have advantages and features which will be more readily apparent from the detailed description, the appended claims, and the accompanying figures (or drawings). A brief introduction of the figures is below.
Figure (FIG.) 1 is an example of a remote controlled aerial vehicle in communication with a remote controller.
FIG. 2 illustrates an example of a remote controlled aerial vehicle.
FIG. 3 illustrates an example of a remote controller.
FIG. 4A illustrates a Cartesian coordinate system defined relative to the direction of a radiation direction of the remote controller's antennas.
FIGS. 4B, 4C, and 4D illustrate the main lobes of the radiation patterns of example directional antennas.
FIG. 5 illustrates a block diagram of an example remote controller architecture.
FIG. 6 illustrates a block diagram of an example camera architecture.
FIGS. 7A, 7B, and 7C illustrate example user interfaces of a remote controller.
FIG. 8 is a block diagram illustrating a method of providing feedback to a user to assist the user in orienting the remote controller.
FIGS. 9A and 9B are cutaway illustrations of an example remote controller showing two antennas.
FIGS. 10 and 11 illustrate a remote controller with the screen rotated to a horizontal and vertical position, respectively, according to an embodiment.
FIGS. 12A, 12B, and 12C illustrate a radiation pattern of an antenna of a remote controller when the screen of the remote controller is rotated to a horizontal position, according to an embodiment.
FIGS. 13A, 13B, and 13C illustrate a radiation pattern of an antenna of a remote controller when the screen of the remote controller is rotated to a vertical position, according to an embodiment.

### DETAILED DESCRIPTION

The Figures (FIGS.) and the following description relate to preferred embodiments by way of illustration only. It should be noted that from the following discussion, alternative embodiments of the structures and methods disclosed herein will be readily recognized as viable alternatives that may be employed without departing from the principles of what is claimed.

Reference will now be made in detail to several embodiments, examples of which are illustrated in the accompanying figures. It is noted that wherever practicable similar or like reference numbers may be used in the figures and may indicate similar or like functionality. The figures depict embodiments of the disclosed system (or method) for purposes of illustration only. One skilled in the art will readily recognize from the following description that alternative embodiments of the structures and methods illustrated herein may be employed without departing from the principles described herein.

### CONFIGURATION OVERVIEW

Disclosed, by way of example embodiments, is a device communicatively coupled to an aerial vehicle. The device may be, for example, a remote controller that allows a user to control the aerial vehicle. The device includes one or more directional antennas which provides for antenna gain. Compared to the theoretical isotropic antenna, the power transmitted or received by directional antennas will be greater in a certain region of space, but weaker in another region. A directional antenna may be configured to have a main beam in which the signal power is the highest.

The aerial vehicle may detect its global position, heading, and altitude using some combination of a global positioning satellite (GPS) receiver, gyroscopes, accelerometers, a barometer, and a magnetometer. The aerial vehicle transmits this position and heading information to the communicatively coupled device. The device also may detect its own global position and heading, and estimates the position and heading of the aerial vehicle relative to itself. The device may then determines whether its antenna(s) is/are oriented so as to provide maximum (or sufficient) signal power in the direction of the aerial vehicle based on the estimated distance vector between the aerial vehicle and the device communicatively coupled with the aerial vehicle, the detected orientation of the device, and *a priori* information stored on the device about the radiation pattern (e.g., the far field pattern) of one or more antennas of the device.

If the current orientation of the device is not optimal, the device may display on a screen an indication that the device should be reoriented relative to the location of the aerial vehicle. This indication may include, for example, a visual indicator on a display of the aerial vehicle or an audio queue output by an electroacoustic transducer of the device. In this manner, the device coupled to the aerial vehicle may provide the user with feedback which allows the user to orient the device optimally for communication with the aerial vehicle.

If the device uses the same antenna for transmission and reception, due to the reciprocity theorem of electromagnetics, the direction in which the sensitivity of the antenna of the device to received signals is maximized is the same direction in which the transmission power is maximized. Thus, adjust the position of the antenna of the device to improve signal transmission will also improve signal reception.

### EXAMPLE AERIAL VEHICLE CONFIGURATION

Figure (FIG.) 1 illustrates an example embodiment in which an aerial vehicle 110 is a quadcopter (i.e., a helicopter with four rotors). The aerial vehicle 110 in this example includes a housing 130 for payload (e.g., electronics, storage media, and/or camera), four arms 135, four rotors 140, and four propellers 145. Each arm 135 may mechanically couple with a rotor 140 to create a rotary assembly. When the rotary assembly is operational, all the propellers 145 may spin at appropriate speeds to allow the aerial vehicle 110 lift (take off), land, hover, move, and rotate in flight. Modulation of the power supplied to each of the rotors 140 may control the acceleration and torque on the aerial vehicle 110.

A gimbal 175 may be coupled to the housing 130 of the aerial vehicle 110 through a removable coupling mechanism that mates with a reciprocal mechanism on the aerial vehicle 110. The coupling between the gimbal 175 and the aerial vehicle 110 may have mechanical and communicative capabilities. In some embodiments, the gimbal 175 may be attached or removed from the aerial vehicle 110 without the use of tools. A camera 115 may be mechanically coupled to the gimbal 175, so that the gimbal 175 steadies and controls the orientation of the camera 115. It is noted that in alternate embodiments, the camera 115 and the gimbal 175 may be an integrated configuration.

The aerial vehicle 110 may communicate with a device via a wireless network 125. The device that communicates with the aerial vehicle 110 is described herein as being a remote controller 120. However, in alternate embodiments, the device may be any other computing device capable of wireless communicating (e.g., transmitting, receiving, or both) with the aerial vehicle 110. Some or all of the description attributed herein to the remote controller 120 may also be applied to other computing devices capable of wireless communication. Other computing devices may include a device with a screen that is used to display images or video captured by the aerial vehicle but not to control the aerial vehicle, such as, a laptop, smartphone, tablet, or head-mounted display.

In one embodiment, the wireless network 125 may be a long range Wi-Fi system. It also may include or be another wireless communication system, for example, one based on long term evolution (LTE), 3G, 4G, or 5G mobile communication standards. In some embodiments, the wireless network 125 consists of a single channel and the aerial vehicle 110 and the remote controller 120 implement a half-duplex system. In an alternate embodiment, the wireless network 125 includes two channels: a unidirectional channel used for communication of control information from the remote controller 120 to the aerial vehicle 110 and a separate unidirectional channel used for video downlink from the aerial vehicle 110 to the remote controller 120 (or to another device, such as a video receiver where direct video connection may be desired). Alternate wireless network configurations may also be used.

The remote controller 120 in this example includes a first control panel 150, a second control panel 155, an ignition button 160, a return button 165, and a screen (or display) 170. The first control panel 150 may be used to control "up-down" direction (e.g. lift and landing) of the aerial vehicle 110. The second control panel 155 may be used to control "forward-reverse" or may control the direction of the aerial vehicle 110. In alternate embodiments, the control panels 150, 155 are mapped to different directions for the aerial vehicle 110. Each control panel 150, 155 may be structurally configured as a joystick controller and/or touch pad controller. The ignition button 160 may be used to start the rotary assembly (e.g., start the propellers 145). The return button 165 may be used to override the controls of the remote controller 120 and transmit instructions to the aerial vehicle 110 to autonomously return to a predefined location. The ignition button 260 and the return button 265 may be mechanical and/or solid state press sensitive buttons.

In addition, each button may be illuminated with one or more light emitting diodes (LEDs) to provide additional details. For example a LED may switch from one visual state to another to indicate with respect to the ignition button 160 whether the aerial vehicle 110 is ready to fly (e.g., lit green) or not (e.g., lit red) or whether the aerial vehicle 110 is now in an override mode on return path (e.g., lit yellow) or not (e.g., lit red). It also is noted that the remote controller 120 may include other dedicated hardware buttons and switches and those buttons and switches may be solid state buttons and switches. For example, a button or switch may be configured to allow for triggering a signal to the aerial vehicle 110 to immediately execute a landing operation.

The remote controller 120 may also include hardware buttons or other controls that control the gimbal 175 or camera 115. The remote controller 120 may allow it's user to change the preferred orientation of the camera 115. In some embodiments, the preferred orientation of the camera 115 may be set relative to the angle of the aerial vehicle 110. In another embodiment, the preferred orientation of the camera 115 may be set relative to the ground. The remote controller 120 may also transmit commands to the aerial vehicle 110 which are routed to the camera 115 through the gimbal 175 to take a picture, record a video, change a picture or video setting, and the like.

The remote controller 120 also may include a screen 170 which provides for visual display. The screen 170 may be a touch sensitive screen. The screen 170 also may be, for example, a liquid crystal display (LCD), an LED display, an organic LED (OLED) display, or a plasma screen. The screen 170 may allow for display of information related to the remote controller 120, such as menus for configuring the remote controller 120 or remotely configuring the aerial vehicle 110. The screen 170 also may display images or video captured from the camera 115 coupled with the aerial vehicle 110, wherein the images and video are transmitted to the remote controller 120 via the wireless network 125. The video content displayed on the screen 170 may be a live feed of the video or a portion of the video captured by the camera 115. It is noted that the video content may be displayed on the screen 170 within a short time (e.g., within fractions of a second) of being captured by the camera 115. The delay between the video being captured by the camera 115 and being displayed on the screen 170 may be instantaneous or nearly instantaneous in terms of human perceptual quality.

The video may be overlaid and/or augmented with other data from the aerial vehicle 110 such as the telemetric data from a telemetric subsystem of the aerial vehicle 110. The telemetric subsystem may include navigational components, such as a gyroscope, an accelerometer, a compass, a global positioning system (GPS) and/or a barometric sensor. In one example embodiment, the aerial vehicle 110 may incorporate the telemetric data with video that is transmitted back to the remote controller 120 in real time. The received telemetric data may be extracted from the video data stream and incorporated into predefine templates for display with the video on the screen 170 of the remote controller 120. The telemetric data also may be transmitted separate from the video from the aerial vehicle 110 to the remote controller 120. Synchronization methods such as time and/or location information may be used to synchronize the telemetric data with the video at the remote controller 120. This example configuration may allow a user of the remote controller 120 to see where the aerial vehicle 110 is flying along with corresponding telemetric data associated with the aerial vehicle 110 at that point in the flight. Further, if the user is not interested in telemetric data being displayed real-time, the data may still be received and later applied for playback with the templates applied to the video.

The predefine templates may correspond with "gauges" that provide a visual representation of speed, altitude, and charts, e.g., as a speedometer, altitude chart, and a terrain map. The populated templates, which may appear as gauges on a screen 170 of the remote controller 120, may further be shared, e.g., via social media, and or saved for later retrieval and use. For example, a user may share a gauge with another user by selecting a gauge (or a set of gauges) for export. Export may be initiated by clicking the appropriate export button, or a drag and drop of the gauge(s). A file with a predefined extension may be created at the desired location.

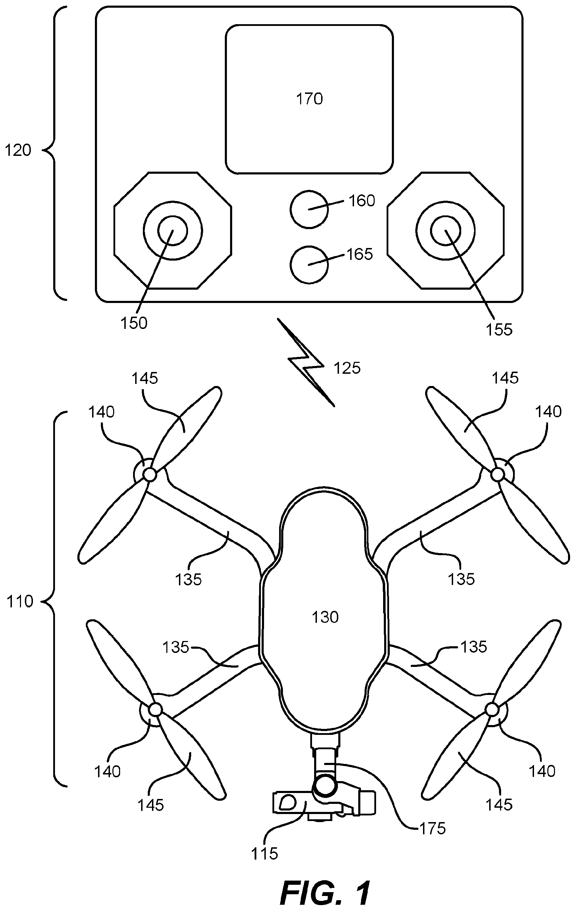

The remote controller 120 shown in FIG. 1 is a dedicated remote controller, but in alternate embodiments the remote controller may be another computing device such as a laptop, smartphone, or tablet that is configured to wirelessly communicate directly through an antenna system with the aerial vehicle 110 to control the aerial vehicle 110.

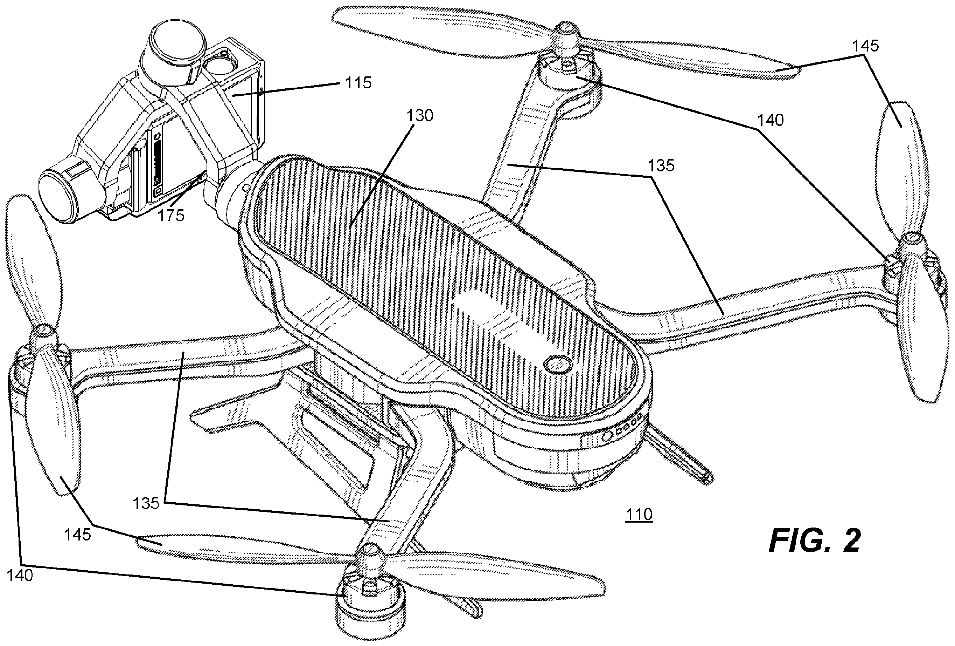

FIG. 2 illustrates an example of an aerial vehicle 110. The aerial vehicle 110 may be coupled to a camera 115 via a gimbal 175. The camera 115 may capture video and send the video to the aerial vehicle 110 through a bus of the gimbal 175. The aerial vehicle 110 may wirelessly transmit the video to the remote controller 120. The aerial vehicle 110 may include one or more internal antennas in the housing 130 for transmitting signals to and receiving signals from the remote controller 120. The one or more antennas may be omnidirectional. In some embodiments, the antennas of the aerial vehicle 110 radiate the majority of their power beneath the aerial vehicle 110 (e.g., in the semi-sphere beneath the aerial vehicle 110).

### EXAMPLE REMOTE CONTROLLER

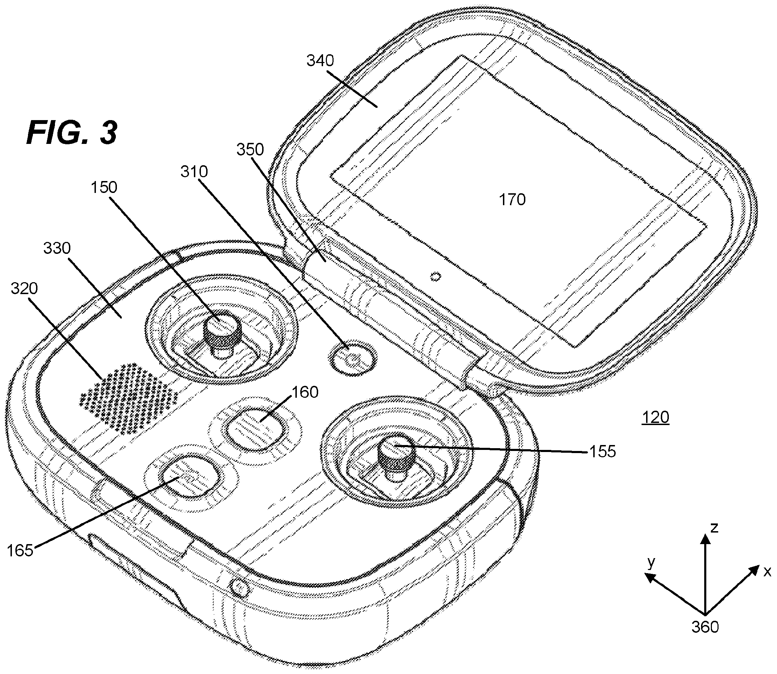

FIG. 3 illustrates an example of a remote controller 120. The remote controller 120 may communicatively couple with an aerial vehicle 110, for example, via a wireless communication protocol such as Wi-Fi. The remote controller 120 may include a first section 330 and a second section 340 which may fold together via a hinge 350 connecting the two sections. The first section 330 may include a first control panel 150, a second control panel 155, an ignition button 160, a return button 165, a power button 310, and a speaker 320. The first section 330 also may include a housing containing electronics, such as processors and antennas. The second section 340 may include a screen 170. The hinge 350 may allow the first section 330 and second section 340 to rotate relative to each other. The hinge 350 may include one or more cams (e.g., v-cams) so that the hinge 350 may fix the rotation of the first section 340 and second section 340 to a finite number of angles. For example, the hinge 350 may be fixed at a 0° rotation (i.e., where the remote controller 120 is closed), a 90° rotation (i.e., where the screen 170 is perpendicular to the face of the first section 330), and 170° rotation (as shown in FIG. 3). In some embodiments, the hinge 350 may be an adjustable friction hinge so that the user can adjust the relative orientation of the first section 330 and the second section 340.

The remote controller 120 may include a screen 170 and a speaker 320 (e.g., an electroacoustic transducer) for providing output to a user. The speaker 320 may output sound from a video as it is displayed on the screen 170. The video may be received from the aerial vehicle 110 via the wireless network 125. The speaker 320 may also output sounds responsive to the user pressing a button or as an alert to the user. For example, the speaker may output an alert when the battery of the aerial vehicle 110 is nearly depleted, when an error is detected on the aerial vehicle 110 (e.g., a mechanical malfunction, a software error, an electronic malfunction, or a combination thereof), when the signal strength between the aerial vehicle 110 and the remote controller 120 is weak, when the antenna of the remote controller 120 is not oriented correctly, and/or when the wireless connection with the aerial vehicle 110 is lost.

The remote controller 120 also includes user input devices. Specifically, the remote controller 120 may include a first control panel 150, a second control panel 155, an ignition button 160, a return button 165, and a power button 310. The first control panel 150 and the second control panel, 155 may be joystick controllers for controlling the velocity and orientation of the aerial vehicle 110. The power button 310 may toggle the power of the remote controller 120 or toggle the power of the aerial vehicle 110. In some embodiments, the screen 170 may be a touch screen and thus can receive user inputs as well.

The remote controller 120 may contain one or more internal directional antennas (not shown in FIG. 3). For example, the remote controller 120 may include two ceramic patch antennas. In some embodiments, the controller 120 uses both antennas for transmission and reception. In alternate embodiments, one antenna is used for reception and the other for transmission. The remote controller 120 may also include a Yagi-Uda antenna, a log-periodic antenna, a parabolic antenna, a short backfire antenna, a loop antenna, a helical antenna, a phased array of antennas, any other direction antenna, or some combination thereof.

The radiation patterns of the one or more directional antenna of the remote controller 120 are discussed herein with respect to the standard Cartesian coordinate system in 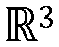 where the x-y plane is the horizontal plane and where the z-axis is in the upward vertical direction. The one or more directional antenna of the remote controller 120 may be configured such that the main beam direction (i.e., the direction of greatest radiated energy) of each antenna is horizontal when the remote controller 120 is held horizontally. In some embodiments, the main beam directions of the antennas may be directed above the horizontal plane.

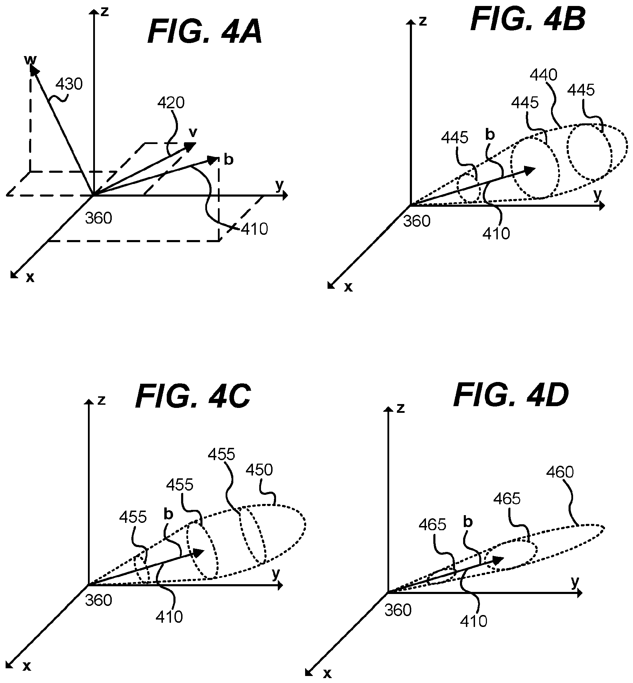

Turning now to FIG. 4A, it depicts a second Cartesian coordinate system defined by the set of orthonormal basis vectors {***b,w,v***} in relation to the first coordinate system defined by the x, y, and z axes 360. Herein, the origin of the radiation pattern of the one or more directional antennas of the remote controller 120 is considered to be centered at (x,y,z)=(0,0,0). The vectors {***b**,**w**,**v***} are defined herein based on the radiation pattern of the remote controller 120 to assist in describing the radiation pattern of the remote controller 120.

The radiation direction vector ***b*** 410 is defined herein as a unit vector in the direction of the radiation of the one or more antennas of the remote controller 120. In general, the radiation direction vector ***b*** 410 is the direction in which the one or more antennas of the remote controller 120 best transmit signals to and receive signals from the aerial vehicle 110. If the remote controller 120 has a single antenna or if every antenna has the same main beam axis, the direction of ***b*** 410 may be the direction of the main beam axis. The main beam axis of a directional antenna is the direction of maximum gain of the direction antenna (i.e., the boresight direction of the antenna). In embodiments where the remote controller 120 includes more than one antenna, the radiation direction ***b*** 410 may be the average of the beam axis directions of each antenna. The radiation direction ***b*** 410 may also be configured to be the optimal direction for communication using the antennas.

The second vector, ***v*** 420, is the unit vector orthogonal to the radiation direction vector ***b*** 410 and parallel with the horizontal side of the screen 170. In the normal orientation of the remote controller 120 (i.e., without roll rotation), ***v*** 420 is on the x-y plane. In an embodiment where the remote controller 120 lacks a screen 170, ***v*** 420 may be synonymously defined as being on the horizontal plane (i.e., the x-y plane) when the remote controller 120 is held at an orientation without a roll rotation. Finally, the third vector, ***w*** 430, is the vector cross product of ***b*** 410 and ***v*** 420. Thus, ***w*** 430 is orthogonal to both ***b*** 410 and ***v*** 420, and when ***v*** 420 is on the x-y plane (i.e., when the remote controller 120 has no roll rotation), ***w*** 430 is on the same vertical plane as ***b*** 410. If the remote controller 120 is held without a roll rotation such that the radiation direction vector ***b*** 410 lies on the x axis, then ***b*** 410, ***v*** 420, and ***w*** 430 lie on the x, y, and z axes, respectively. These vectors {***b**,**w**,**v***} are defined based on the radiation pattern of one or more antennas of the remote controller 120, and, therefore, based on the orientation of the remote controller 120. Thus, any reorientation of the remote controller 120 will also change two or more of the vectors ***b*** 410, ***v*** 420, and ***w*** 430.

FIGS. 4B, 4C, and 4D illustrate three examples of main lobes of the radiation patterns of three example directional antennas which may be used in the remote controller 120, in accordance with various embodiments. Each lobe is depicted with the corresponding radiation direction vector ***b*** 410, which in the case of FIG. 4B, 4C, and 4D, may be the beam axis of the corresponding antenna. The radially symmetric main lobe 440 depicted in FIG. 4B is a pencil beam. Three cross sections 445 of the main lobe 440 are also illustrated. These cross sections 445 may be approximately circular and are parallel to the plane containing ***v*** 420 and ***w*** 430. In this embodiment, the main lobe 440 is approximately symmetrical about the main beam axis (i.e., symmetric about the radiation direction vector ***b*** 410).

FIG. 4C illustrates a thin main lobe 450 of a radiation pattern of the remote controller 120 according to another embodiment. The thin main lobe 450 is "thin" in that it extends further in the direction of ***w*** 430 than in the direction of ***v*** 420. The cross sections 455 of the thin main lobe 450 likewise extend further in the direction **of *w*** 430 than in the direction of ***v*** 420. That is, the cross sections 455 are taller than they are wide. Compared to a radially symmetric main lobe 440, a directional antenna with a thin main lobe 450 may allow for the signal transmitted to the aerial vehicle 110 to be of acceptable power while permitting larger variance in beam direction in the direction of ***w*** 430. However, the range of values with acceptable transmitted power in the direction of ***v*** 420 may be smaller. In general, this may require the user to orient the beam direction (by orienting the remote controller 120) with high horizontal precision, but with relatively little vertical precision.

FIG. 4D illustrates the wide main lobe 460 of a wide radiation pattern of the remote controller 120 according to yet another embodiment. The wide main lobe 460 is "wide" in that it extends further in the direction of ***v*** 420 than in the direction of ***w*** 430. The cross sections 465 of the wide main lobe 460 likewise extend further in the direction of ***v*** 420 than in the direction of ***w*** 430. That is, the cross sections 465 are wider than they are tall. The wide main lobe 460 may permit greater variance of the beam direction in the direction of ***v*** 420, but may permit less variance in the direction of ***w*** 430. In general, this may require the user to orient the beam direction with high vertical precision, but with relatively little horizontal precision.

### EXAMPLE REMOTE CONTROL SYSTEM

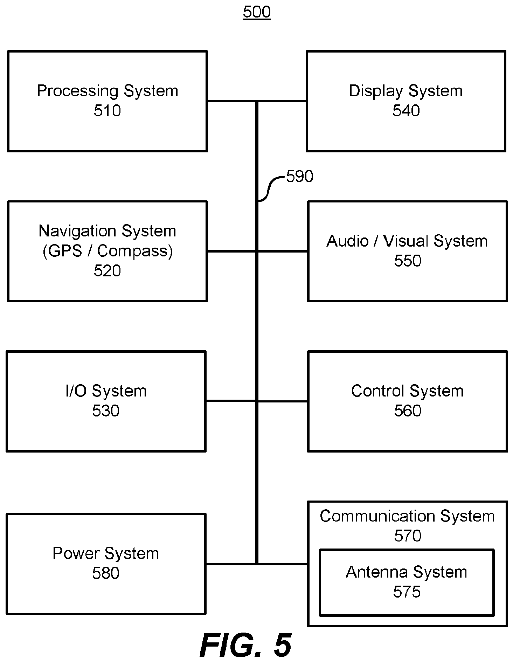

FIG. 5 illustrates a block diagram of an example architecture of a remote controller, e.g., remote controller 120. The remote controller architecture 500 may include a processing system 510, a navigation system 520, an input/output (I/O) system 530, a display system 540, an audio/visual system 550, a control system 560, a communication system 570, and a power system 580. The systems may be communicatively coupled through a data bus 590 and are powered, where necessary, through the power system 580. The communication system 570 may couple to antenna system 575.

The processing system 510 may be configured to provide the electronic processing infrastructure to execute firmware and software comprised of instructions. The processing system 510 may include one or more hardware processors.

The navigation system 520 may include electronics, controls, and interfaces for navigation instrumentation of the remote controller 120. The navigation system 520 may include a global position system (GPS) receiver, a compass (e.g., a magnetometer), gyroscopes, accelerometers, a barometer, or some combination thereof. The GPS receiver, accelerometers, gyroscopes, and compass may be used to track the location, motion, and orientation of the remote controller 120.

The I/O system 530 may include the input and output interfaces and electronic couplings to interface with devices that allow for transfer of information into or out of the remote controller 120. For example, the I/O system 530 may include a physical interface such as a universal serial bus (USB) or a media card (e.g., secure digital (SD)) slot. The I/O system 530 also may be associated with the communication subsystem 570 to include a wireless interface such as Bluetooth™. In addition, it is noted that in one example embodiment, the aerial vehicle 110 may use long range Wi-Fi radio within the communication system 570, but may also use a second Wi-Fi radio or cellular data radio (as a part of the I/O system 530) for connection to other wireless data enabled devices, for example, smart phones, tablets, laptop or desktop computers, and wireless internet access points. Moreover, the I/O system 530 may also include other wireless interfaces, e.g., Bluetooth, for communicatively coupling devices that are similarly wirelessly enabled for short range communications.

The display system 540 may be configured to provide an interface, electronics, and display drivers for one or more display screens (e.g., the screen 170 of the remote controller 120). The audio/visual system 550 may include the interfaces, electronics, and drivers for an audio output (e.g., headphone jack or speakers) as well as visual indicators (e.g., LED lighting associated with, for example, the buttons 160, 165 of the remote controller 120). The control system 560 may include electronic and control logic and firmware for operation with the control panels 150, 155.

The communication system 570 may include electronics, firmware, and interfaces for communications. The communications system 570 may include one or more of wireless communication mechanisms such as Wi-Fi (short and long range), LTE, 3G/4G/5G, and the like. The communication system 570 also may include wired communication mechanisms such as Ethernet, USB, and high-definition multimedia interface (HDMI). The communication system 570 may include an antenna system 575 coupled to a receiver, transmitter, or transceiver. The antenna system 575 may include one or more antennas. A transceiver of the communication system 570 may transmit and receive data with the antenna system 575 to communicate over the wireless network 125. Prior to transmitting data from the remote controller 120, the transceiver may process the data by performing encryption, scrambling, forward error correction coding (FEC), lossless compression, lossy compression, or some combination thereof. Similarly, the transceiver may process data received over the wireless network 125 by performing decryption, unscrambling, error correction decoding, decompression, or some combination thereof.

The power system 580 may include electronics, firmware and interfaces for providing power to the system. The power system 580 may include direct current (DC) power sources (e.g., batteries), but also may be configured for alternating current (AC) power sources. The power system 580 also may include power management processes for extending DC power source lifespan. It is noted that in some embodiments, the power system 580 may be comprised of a power management integrated circuit and a low power microprocessor for power regulation. The microprocessor, in such embodiments, may be configured to provide very low power states to preserve battery, and have the ability to wake from low power states in response to such events as a button press or an on-board sensor (e.g., a hall sensor) trigger.

### EXAMPLE CAMERA ARCHITECTURE

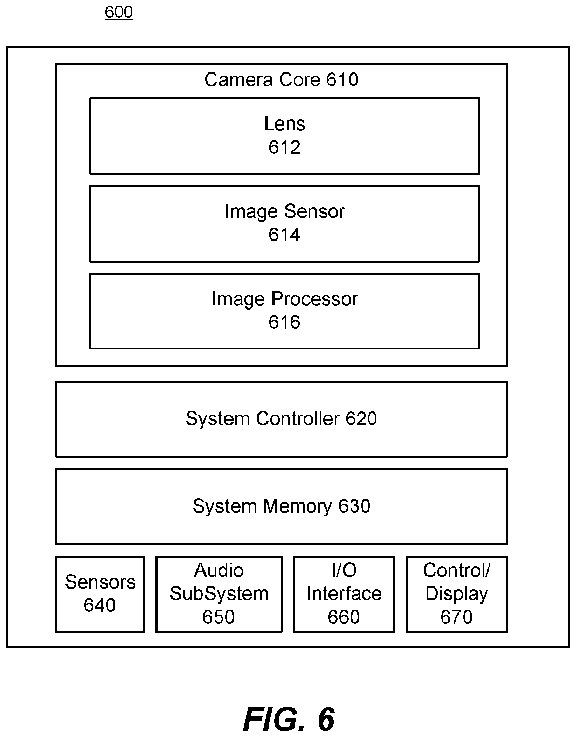

FIG. 6 illustrates a block diagram of an example camera architecture. The camera architecture 600 may be an architecture for a camera, e.g., camera 115. The camera architecture 600 may include a camera body, one or more a camera lenses, various indicators on the camera body (such as LEDs, displays, and the like), various input mechanisms (such as buttons, switches, and touch-screen mechanisms), and electronics (e.g., imaging electronics, power electronics, metadata sensors, etc.) internal to the camera body for capturing images via the one or more lenses and/or performing other functions. In one embodiment, the camera 115 may be capable of capturing spherical or substantially spherical content. As used herein, spherical content may include still images or video having spherical or substantially spherical field of view. For example, in one embodiment, the camera 115 may capture video having a 360° field of view in the horizontal plane and a 180° field of view in the vertical plane. Alternatively, the camera 115 may capture substantially spherical images or video having less than 360° in the horizontal direction and less than 180° in the vertical direction (e.g., within 10% of the field of view associated with fully spherical content). In other embodiments, the camera 115 may capture images or video having a non-spherical wide angle field of view.

As described in greater detail below, the camera 115 may include sensors 640 to capture metadata associated with video data, such as timing data, motion data, speed data, acceleration data, altitude data, GPS data, and the like. In a particular embodiment, location and/or time centric metadata (e.g., geographic location, time, and/or velocity) may be incorporated into a media file together with the captured content in order to track the location of the camera 115 over time. This metadata may be captured by the camera 115 itself or by another device (e.g., a mobile phone or the aerial vehicle 110) proximate to the camera 115. In one embodiment, the metadata may be incorporated with the content stream by the camera 115 as image content is being captured. In another embodiment, a metadata file separate from the video file may be captured (by the same capture device or a different capture device) and the two separate files may be combined or otherwise processed together in post-processing. It is noted that these sensors may be in addition to the sensors 640 of the camera 115. In embodiments in which the camera 115 is integrated into the aerial vehicle 110, the camera 115 need not have separate individual sensors, but rather may rely upon the sensors integrated with the aerial vehicle 110.

Referring now to the details of FIG. 6, it illustrates a block diagram of the camera architecture 600 of the camera 115, according to one embodiment. In the illustrated embodiment, the camera 115 may include a camera core 610 that includes a lens 612, an image sensor 614, and an image processor 616. The camera 115 additionally may include a system controller 620 (e.g., a microcontroller or microprocessor) that controls the operation and functionality of the camera 115 and a system memory 630 configured to store executable computer instructions that, when executed by the system controller 620 and/or the image processors 616, perform the camera functionalities described herein. In some embodiments, a camera 115 may include multiple camera cores 610 to capture fields of view in different directions which may then be stitched together to form a cohesive image. For example, in an embodiment of a spherical camera system, the camera 115 may include two camera cores 610 each having a hemispherical or hyper-hemispherical lens that each captures a hemispherical or hyper-hemispherical field of view which are stitched together in post-processing to form a spherical image.

The lens 612 may be, for example, a normal lens, a wide angle lens, a hemispherical lens, or a hyper-hemispherical lens that focuses light entering the lens to the image sensor 614 which captures images and/or video frames. The image sensor 614 may capture high-definition images having a resolution of, for example, 720p, 1080p, 4k, or higher. For video, the image sensor 614 may capture video at frame rates of, for example, 30 frames per second, 60 frames per second, or higher. The image processor 616 may perform one or more image processing functions on the captured images or video. For example, the image processor 616 may perform a Bayer transformation, demosaicing, noise reduction, image sharpening, image stabilization, rolling shutter artifact reduction, color space conversion, compression, or other in-camera processing functions. Processed images and video may be temporarily or persistently stored to system memory 630 and/or to a non-volatile storage, which may be in the form of internal storage or an external memory card.

An input/output (I/O) interface 660 may transmit and receive data from various external devices. For example, the I/O interface 660 may facilitate the receiving or transmitting of video or audio information through an I/O port. Examples of I/O ports or interfaces include USB ports, HDMI ports, Ethernet ports, audio ports, and the like. Furthermore, embodiments of the I/O interface 660 may include wireless ports that can accommodate wireless connections. Examples of wireless ports include Bluetooth, Wireless USB, Near Field Communication (NFC), and the like. The I/O interface 660 may also include an interface to synchronize the camera 115 with other cameras or with other external devices, such as a remote control, a second camera, a smartphone, a client device, or a video server.

A control/display subsystem 670 may include various control and display components associated with operation of the camera 115 including, for example, LED lights, a display, buttons, microphones, speakers, and the like. The audio subsystem 650 may include, for example, one or more microphones and one or more audio processors to capture and process audio data correlated with video capture. In one embodiment, the audio subsystem 650 may include a microphone array having two or more microphones arranged to obtain directional audio signals.

The sensors 640 capture various metadata concurrently with, or separately from, video capture For example, the sensors 640 may capture time-stamped location information based on a global positioning system (GPS) sensor, and/or an altimeter. Other sensors 640 may be used to detect and capture the orientation of the camera 115 including, for example, an orientation sensor, an accelerometer, a gyroscope, or a magnetometer. Sensor data captured from various sensors on the aerial vehicle 110 may be processed to generate other types of metadata. For example, sensor data from the accelerometer may be used to generate motion metadata which may include velocity and/or acceleration vectors representative of motion of the camera 115. Furthermore, sensor data from the aerial vehicle 110 and/or the gimbal 175 may be used to generate orientation metadata describing the orientation of the camera 115. Sensor data from a GPS receiver may provide GPS coordinates identifying the location of the camera 115, and an altimeter may measure the altitude of the camera 115. In one embodiment, the sensors 640 may be rigidly coupled to the camera 115 such that any motion, orientation, or change in location affecting the camera 115 also affects the sensors 640. The sensors 640 furthermore may associates a time stamp representing when the data was captured by each sensor. In one embodiment, the sensors 640 may automatically begin collecting sensor metadata when the camera 115 begins recording a video.

### EXAMPLE REMOTE CONTROL USER INTERFACE

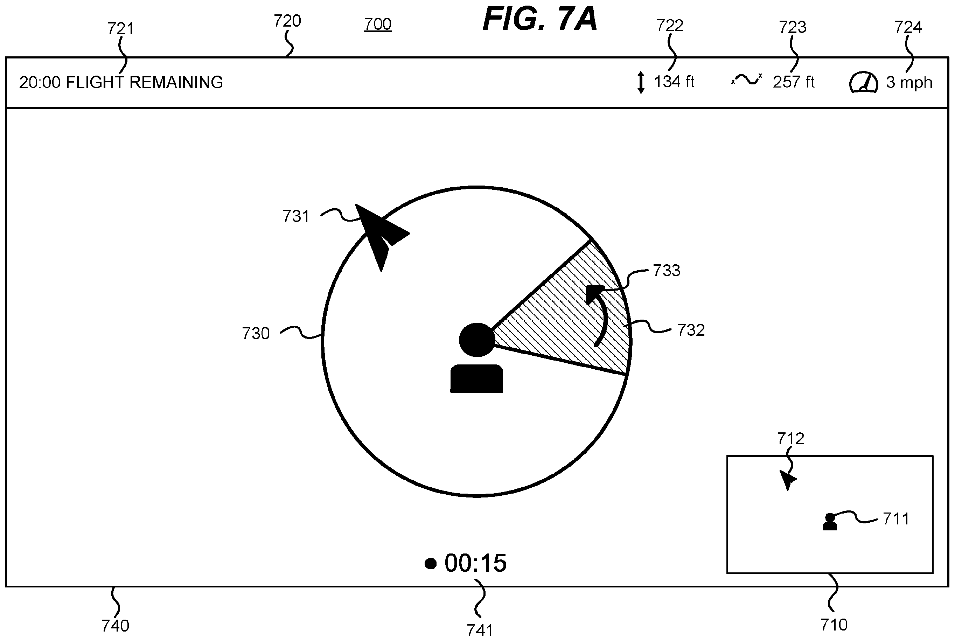

FIG. 7A illustrates an example user interface for display on a screen of a remote controller. The user interface 700 may be displayed on a screen, such as the screen 170 of the remote controller 120. The user interface 700 may display information indicating the position of the aerial vehicle 110 relative to the remote controller 120 as well as state information about the aerial vehicle 110 such as its velocity, altitude, and speed. The user interface 700 may include a map 710, an information panel 720, an antenna direction indicator 730, and a video panel 740.

The map 710 may include a user indicator 711 and a vehicle indicator 712, which indicate the geographic position of the remote controller 120 and the aerial vehicle 110, respectively. The map 710 may also display a vector map which displays geographic features such as bodies of water, rivers, cliffs, inclines, mountains, or other geographical features. The vector map may be a two-dimensional (2D) map or a three-dimensional (3D) map. In some embodiments, the 3D vector map is displayed as a topographical map. The vector map may also display manmade features such as roads, hiking paths, the footprint of buildings, 3D models of buildings, and notable landmarks. In some embodiments, the map 710 also displays overhead imagery, such as satellite imagery.

The relative position of the elements displayed on the map 710 may be indicative of the location of corresponding geographical and manmade features. The map 710 may display a subsection of a vector map or image stored on the remote controller 120. In some embodiments, the remote controller 120 may receive maps based on its detected GPS location from a remote server through a wireless network.

The information panel 720 displays information relating to the aerial vehicle 110. The information panel 720 may include a remaining flight time indicator 721, an altitude indicator 722, a horizontal distance indicator 723, and a speedometer 724. The information displayed in the information panel 720 may be received from the aerial vehicle 110 via the wireless network 125. The remaining flight time indicator 721 may display an estimate of the time until the battery of the aerial vehicle 110 is depleted based on the current charge of the battery of the aerial vehicle 110 and/or the logged flight path of the aerial vehicle 110. The altitude indicator 722 may display the altitude of the aerial vehicle 110, where altitude is measured in units of distance (e.g., feet, yards, meters, etc.). The displayed altitude may be relative to the remote controller 120, the lift-off location, the ground directly underneath the aerial vehicle 110, a user defined altitude, or an absolute altitude (e.g., mean sea level).

The distance indicator 723 may display either the displacement of the aerial vehicle 110 from some reference position or a total path length. In some embodiments, the distance indicator 723 may display a displacement of the aerial vehicle 110 from the remote controller 120, the lift-off location, or a user defined position. In alternate embodiments, the distance indicator 723 may display a total path length. The path for which the path length is defined may be the flight path that the aerial vehicle 110 has flown, a programmed flight path which the aerial vehicle 110 is configured to automatically follow, or an automatic return to home path. The displacement or the path length displayed by the distance indicator 723 may be the total displacement or path length or may be the horizontal component of the displacement or path length. The speedometer 724 may display the speed of the aerial vehicle 110. The measurement of the speed may be based on the horizontal component of the velocity of the aerial vehicle 110 or may be based on the aerial vehicle's total velocity.

The antenna direction indicator 730 may be a visual indicator that displays the relative position of the aerial vehicle 110. The antenna direction indicator 730 may include a vehicle icon 731, a radiation direction indicator 732, and an orientation adjustment arrow 733. The antenna direction indicator 730 may display an indication of the direction of the displacement vector between the remote controller 120 and the aerial vehicle 110. Herein, this displacement vector is denoted as ***d.*** The vertical component of the direction of ***d*** (i.e., the angle that the displacement vector ***d*** makes with the horizontal plane) is denoted as *θ_{β},* and the horizontal component of the direction of ***d*** relative to some reference direction is denoted as *θ*_{α}. The antenna direction indicator 730 also displays the direction of the radiation pattern of the antenna system 575 of the remote controller 120. As described in conjunction with FIG. 4A, a radiation direction vector ***b*** may be defined based on the direction of the radiation pattern for the antenna system 575 of the remote controller 120. *φ_{β}* and *φ_{α}* denote the vertical and horizontal components, respectively, of the direction of ***b**.*

The position of the vehicle icon 731 on the circle of the antenna direction indicator 730 may be based on *θ_{α}* the horizontal component of the displacement vector ***d*** between the remote controller 120 and the aerial vehicle 110. This angle *θ_{α}* may be relative to a fixed orientation, such as polar north or magnetic north. For example, the vehicle icon 731 is displayed at a 135° position on the circle in FIG. 7A, which indicates that the aerial vehicle 110 is north west of the remote controller 120. The orientation of the vehicle icon 731 may be indicative of the orientation or the heading of the aerial vehicle 110. In alternate embodiments, the orientation of the vehicle icon 731 may be indicative of the orientation of a camera 115 coupled to the aerial vehicle 110.

If the remote controller 120 completely loses its connection with the aerial vehicle 110, the vehicle icon 731 may remain at the same position. In embodiments in which the aerial vehicle 110 is configured with automatic return to home behavior, the remote controller 120 may predict the position of the aerial vehicle 110 based on the return to home path. The vehicle icon 731 may be displayed on the circle of the antenna direction indicator 730 based on this predicted position to assist the user in restoring the connection with the aerial vehicle 110.

The radiation direction indicator 732 may be a wedge which indicates the horizontal direction *φ_{α}* of the radiation pattern of the antenna system 575 of the remote controller 120. The orientation of the center of the wedge may be based on the horizontal direction *φ_{α}* of the radiation direction vector ***b*** 410, e.g., as shown in FIGS. 4A-4C. In embodiments in which the radiation pattern of the antenna system 575 is fixed to the orientation of the remote controller 120, the orientation of the radiation direction indicator 732 may also be indicative of the orientation of the remote controller 120.

In some embodiments, the arc length of the radiation direction indicator 732 may be based on an arc threshold T*_{α}*. T_{α} is a threshold for the difference between the horizontal direction *φ_{α}* of the radiation direction vector ***b*** 410 and the horizontal direction *θ_{α}* of the displacement vector ***d***. The arc that the radiation direction indicator 732 composes may be the range of angles between *φ_{α}* - T*_{α}* and *φ_{α}* + T*_{α}*. T_{α} may be based on the beamwidth of the main lobes of the antennas of the antenna system 575. The beamwidth may be the angle between the points on the main lobe having half-power (-3 dB) relative to the maximum gain of the antennas of the antenna system 575. In other embodiments, the arc threshold T*_{α}* may be based on the range of yaw angles for which the gain of the remote controller 120 will be sufficient for communication between the remote controller 120 and the aerial vehicle 110. The gain required for communication, and thus the arc threshold T*_{α}*, may be based on the distance between the aerial vehicle 110 and the remote controller 120 and may also be based on the signal attenuation as a function of distance. Accordingly, in such an embodiment, the arc threshold T*_{α}* may decrease as the displacement between the aerial vehicle 110 and the remote controller 120 increases.

In some embodiments, the arc threshold T*_{α}* may be based on the vertical component of the beam direction *φ_{β}* relative to vertical component of the displacement direction *θ_{β}*. That is, the arc length of the radiation direction indicator 732 may be based on the angle between the radiation direction vector ***b*** 410 and the horizontal plane relative to the vertical displacement between the remote controller 120 and the aerial vehicle 110. In general, the arc threshold T*_{α}* is largest when *θ_{β}* = *φ_{β}*.

In some embodiments, the arc threshold T*_{α}* may also be based on the noise detected on the wireless channel used for communication, where higher noise corresponds to a smaller value of the arc threshold T*_{α}*. The noise may be indirectly detected based on received control characters from the aerial vehicle 110. For example, the arc threshold T*_{α}* may be decreased when the remote controller 120 receives negative-acknowledge characters (NACKs) or fails to receive acknowledge characters (ACKs) from the aerial vehicle 110. The arc threshold T*_{α}* may also be decreased based on a high bit error rate (BER) detected by an error-correcting decoder of the communication system 570 of the remote controller 120 or similar channel quality indicators. In alternate embodiments, the arc length of the radiation direction indicator 732 may be invariant.

The antenna direction indicator 730 also may include an orientation adjustment arrow 733. The orientation adjustment arrow 733 may indicate the direction of rotation (e.g., clockwise or counterclockwise), in the horizontal plane, for the user to rotate the remote controller 120 in order to increase the signal power received at the aerial vehicle 110. The antenna direction indicator 730 may indicate the direction of rotation of the remote controller 120 that requires the smallest angular adjustment to align the horizontal component of the radiation direction vector ***b*** 410 of the remote controller 120 with that of the displacement vector ***d*** between the remote controller 120 and the aerial vehicle 110. For example, in FIG. 7A, the orientation adjustment arrow 733 faces in the counterclockwise direction because the horizontal direction of the radiation direction vector ***b*** 410 is (*φ_{α}* = 14° (relative to polar east, measured counterclockwise) and the horizontal component of the displacement vector ***d*** is *θ_{α}* = 132°. Thus, the angle between the horizontal components of *b* 410 and ***d** is* smaller in the counterclockwise direction: 118° in the counterclockwise direction and 242° in the clockwise direction.

The video panel 740 may display video received from the aerial vehicle 110. A camera 115 coupled to the aerial vehicle 110 may capture video and transmit it (e.g., via the aerial vehicle 110) through the wireless network 125. The antenna direction indicator 730, the map 710, or elements thereof may be partially transparent to minimize the obstruction of the video. The video panel 740 may include a recording indicator 741 which indicates that video is being recorded by the camera 115 and displays the length (e.g., in seconds) of the currently recording video.

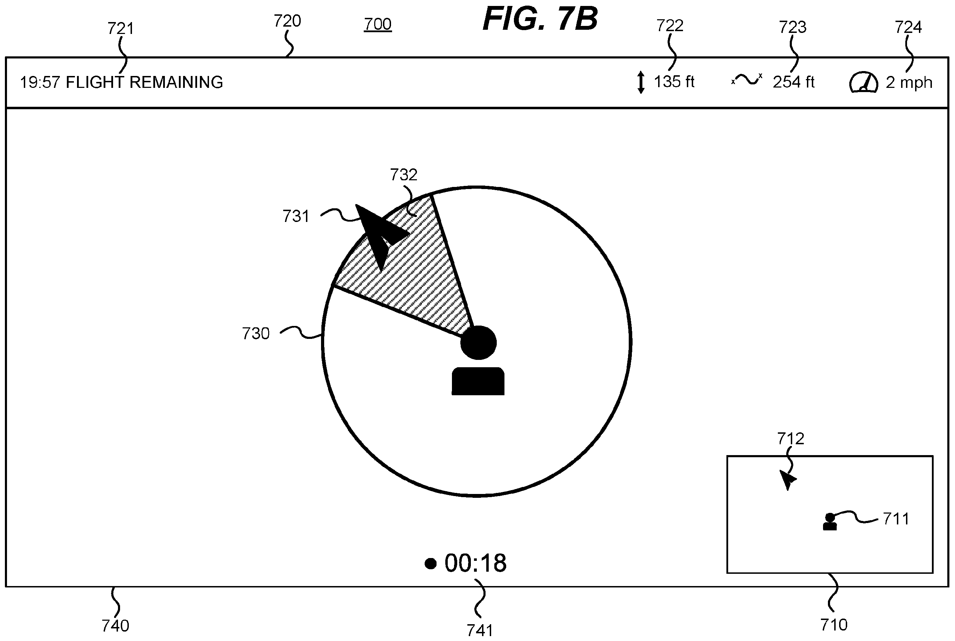

FIG. 7B illustrates the example user interface 700 illustrated in FIG. 7A at a different point in time. FIG. 7B illustrates the user interface 700 after the user has reoriented the remote controller 120 so that the aerial vehicle 110 is in the direction of maximum transmit and receive power of the antenna system 575 (i.e., *φ_{α}* ≈ *θ_{α}*). In the user interface 700, this is illustrated by the vehicle icon 731 inside of the wedge of the radiation direction indicator 732. The orientation adjustment arrow 733 may be omitted when the direction of the radiation direction ***b*** is sufficiently close to the direction of the displacement ***d*** between the remote controller 120 and the aerial vehicle 110.

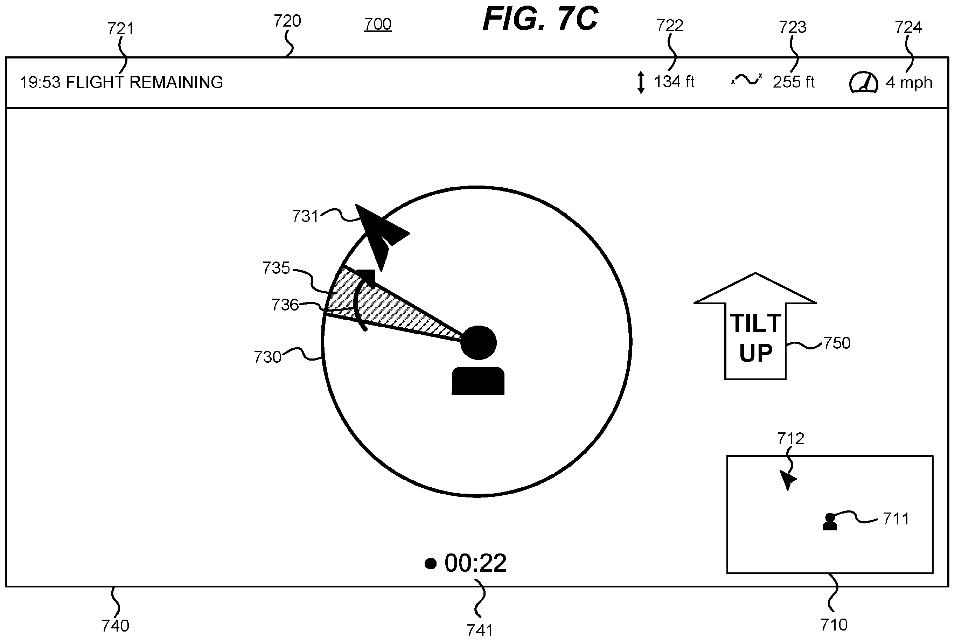

FIG. 7C illustrates the example user interface 700 at a point in time different than that of FIGS. 7A and 7B. FIG. 7C may illustrate the user interface 700 after the user has reoriented the remote controller 120 so that the horizontal component of the radiation direction vector ***b*** 410 of the remote controller is about 30° counterclockwise from the horizontal displacement vector ***d*** between the remote controller 120 and the aerial vehicle 110. Thus, the user interface 700 may display a clockwise orientation adjustment arrow 736 indicating that the user should adjust the yaw of the remote controller 120 in the clockwise direction.

The user interface 700 illustrated in FIG. 7C displays a "tilt up" indicator 750. The tilt up indicator 750 may be displayed responsive to a determination that the pitch of the remote controller 120 is determined to be too low for optimal antenna performance. The pitch may be determined to be too low when is the angle *φ_{β}* between the radiation direction vector ***b*** 410 and the horizontal plane is significantly smaller than the angle *θ_{β}* between the displacement vector ***d*** and the horizontal plane. The tilt up indicator 750 may be displayed responsive to the difference between *θ_{β}* and *φ_{β}* exceeding a threshold *T*_{*β*1}*.* This threshold *T*_{*β*1} may be based on the distance between the aerial vehicle 110 and the remote controller 120, noise detected on the wireless network 125 between the aerial vehicle 110 and the remote controller 120, the transmit power used for either the remote controller 120 or the aerial vehicle 110, or some combination thereof. Similarly, if *φ_{β}* - *θ_{β}* is greater than a second threshold *T*_{*β*2}*,* the user interface 700 may display a tilt down indicator. The thresholds, *T*_{*β*1} and *T*_{*β*2}, which determine whether to display the tilt up indicator 750 or the tilt down indicator, respectively, may be based on the antenna radiation pattern of the remote controller 120.

Depending on the radiation pattern of the antenna system 575, the low pitch of the remote controller 120 may negatively impact the power of signals transmitted between the remote controller 120 and the aerial vehicle 110. In some embodiments, such as when the radiation pattern of the antenna system 575 of the remote controller 120 has a thin main lobe 450 as in FIG. 4C, the effect of the pitch of the remote controller 120 on the transmit and receive power between the remote controller 120 and the aerial vehicle 110 is small. In these embodiments, the user interface 700 may omit a tilt up indicator 750 or tilt down indicator and the arc length of the radiation direction indicator 735 may be invariant with respect to the pitch of the remote controller 120. Alternately, in embodiments that have a relatively wide main lobe 460 as in FIG. 4D, the effect of the pitch of the remote controller 120 on the signal may be relatively large.

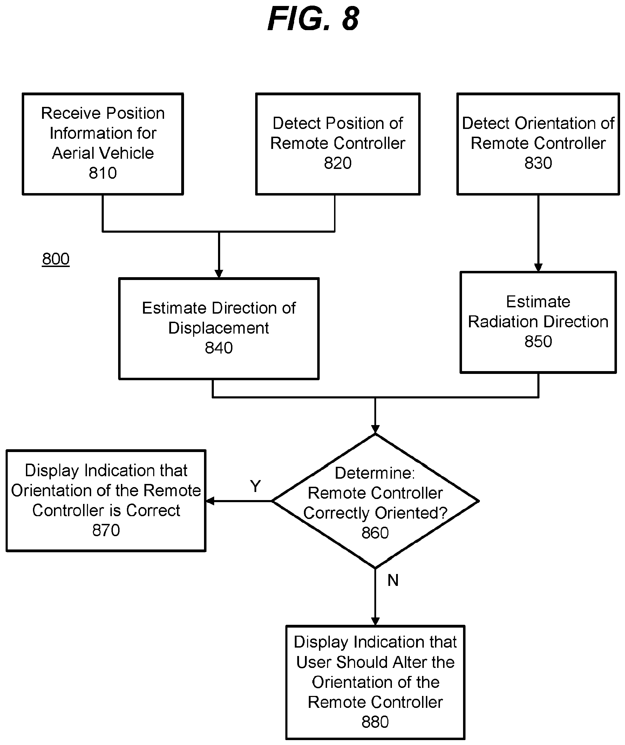

FIG. 8 is a block diagram illustrating an example method of providing feedback to a user to assist the user in orienting the remote controller. The method 800 determines the direction of the radiation direction vector ***b*** 410 of the antenna system 575 of the remote controller 120. A comparison of this direction to the displacement between the detected positions of the remote controller 120 and the aerial vehicle 110 is used to determine whether to display 890 an indication to the user to alter the orientation of the remote controller 120.

The communication system 570 of the remote controller 120 receives 810 position information for the aerial vehicle 110. The aerial vehicle 110 may detect the position information based on sensor data collected by some combination of a GPS receiver, an electronic compass (e.g., a magnetometer), a barometer, and an inertial measurement unit (IMU) on the aerial vehicle 110. The aerial vehicle 110 may transmit the position information to the remote controller 120 through the wireless network 125. The received position information may include absolute position information. For example, the position information may specify the altitude, latitude, and longitude of the aerial vehicle 110. The remote controller 120 may also receive an indication of the some combination of the aerial vehicle's orientation (e.g., a pitch, roll, and yaw), velocity, acceleration, angular velocity, and angular acceleration. In some embodiments, receiving 810 position information for the aerial vehicle 110 includes extrapolating a future position for the aerial vehicle 110 based on previously received position, speed, and acceleration data.

The navigation system 520 of the remote controller 120 detects 820 the position of the remote controller 120. The remote controller 120 then estimates 840 the direction of displacement between the remote controller 120 and the aerial vehicle 110. In some embodiments, the remote controller 120 may estimates 840 the direction of displacement by estimating the displacement vector ***d*** by subtracting the position of the remote controller 120 from the position of the aerial vehicle 110. The direction of displacement may be the direction of horizontal displacement *θ_{α}*. The direction of displacement may also include the direction of vertical displacement *θ_{β}*.

The navigation system 520 of the remote controller 120 also detects 830 the orientation of the remote controller 120. Detecting the orientation of the remote controller 120 may include estimating the yaw, pitch, and/or roll of the remote controller 120 based on sensor data from a GPS receiver, gyroscopes, accelerometers, and/or a magnetometer of the navigation system 520.

The radiation direction vector ***b*** 410 of the antenna system 575 of the remote controller 120 is estimated 850 based on the detected 830 orientation of the remote controller 120. In some embodiments, the direction of the radiation direction vector ***b*** 410 is estimated 850 by applying a rotational transform to a vector representing a reference radiation direction. For example, ***b*₀** may be a vector representing the radiation direction when the remote controller 120 has no yaw, pitch, or roll rotation relative to some reference rotation. The radiation direction vector ***b*** 410 may be given by ***b*** = R(*α*,*β*,γ)×***b***₀ where *α, β,* and *γ* are the yaw, pitch, and roll angles estimated for the remote controller 120 and R(*α*,*β*,γ) is a rotation matrix, as conventionally defined. The reference radiation direction vector ***b*₀** may be a constant stored on the remote controller 120 and may be configured based on a mathematical model of the radiation pattern of the antenna system 575 or empirical methods. Alternately, the reference radiation direction vector ***b*₀** may be variable and may be determined based on a stored model of the radiation pattern of the antenna system 575. In embodiments in which the antenna system 575 may transmit signals at multiple wavelengths, the reference radiation direction vector ***b*₀** may be based on the wavelength of the signal being transmitted or received. Additionally, as discussed further below, the reference beam axis vector ***b*₀** may be based on the rotation of the hinge 350 connecting the first section 330 and the second section 340 of the remote controller 120.

The direction of displacement ***d*** between the remote controller 120 and the aerial vehicle 110 and the radiation direction vector ***b*** 410 may be used to determine 860 whether the remote controller 120 is correctly oriented. This determination may be made by comparing the angle between ***d*** and ***b*** 410 to a threshold value. For example, determining 860 whether the remote controller 120 is correctly oriented may comprise determining whether the absolute angular difference between *θα* and *φ_{α}* is less than T*_{α}* where *θ_{α}* is the direction of the horizontal component of the displacement vector ***d***, *φ_{α}* is the direction of the horizontal component of the radiation direction vector ***b*** 410, and T*_{α}* is a threshold arc length.

If the orientation of the radiation direction vector ***b*** 410 is within an acceptable range, the remote controller 120 may display 870 a user interface (e.g., user interface 700) with an indication that the orientation of the remote controller 120 is correct. In the case of the user interface 700, this is indicated by displaying the vehicle icon 731 inside of the radiation direction indicator 732. In some embodiments, the radiation direction indicator may change visual characteristics, e.g., color and/or visual patterns, based on the determination of whether the remote controller 120 is correctly oriented. For example, the radiation direction indicator 732 may be a first color (e.g., green) when the remote controller 120 is correctly oriented and a second color (e.g., red) when it is not. The colors may also have varying gradients based on how close the orientation of the remote controller 120 is to ideal. For example, the radiation direction indicator 732 may be displayed as red when not oriented correctly (e.g., a large orientation difference), pink when closer to being oriented correctly, light green when nearly oriented correctly, to dark green when correctly oriented.

Further, it is noted that other indicators may be used, e.g., audio or tactile feedback. For example, in the case of audio, the remote controller 120 may output no audio when the remote controller 120 is correctly oriented and may outputs audio beeps of different duration and/or frequency played when it is not. The frequency, duration, or loudness of the beeps may correspond to the magnitude of the orientation error of the remote controller 120. By way of example, in the case of tactile feedback, a touch sensitive surface may produce no vibration when the remote controller 120 is correctly oriented, but may produce vibrations of different duration and/or frequency (e.g., with one or more haptic actuators) when it is not. The frequency or duration of the vibrations may correspond to the magnitude of the orientation error of the remote controller 120.

If, on the other hand, the determination is made that the remote controller 120 is not correctly oriented, an indication that the user should alter the orientation of the remote controller 120 may be displayed 880. In the case of user interface 700, this may be indicated by displaying the vehicle icon 731 outside of the radiation direction indicator 732 and/or by displaying a tilt up indicator 750 or a tilt down indicator.

### EXAMPLE REMOTE CONTROLLER ANTENNAS

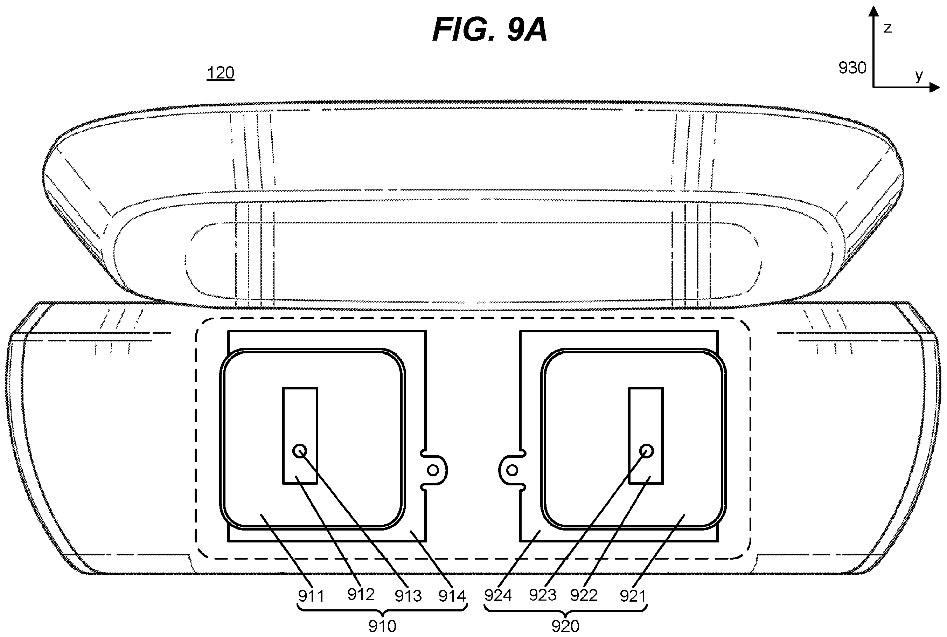

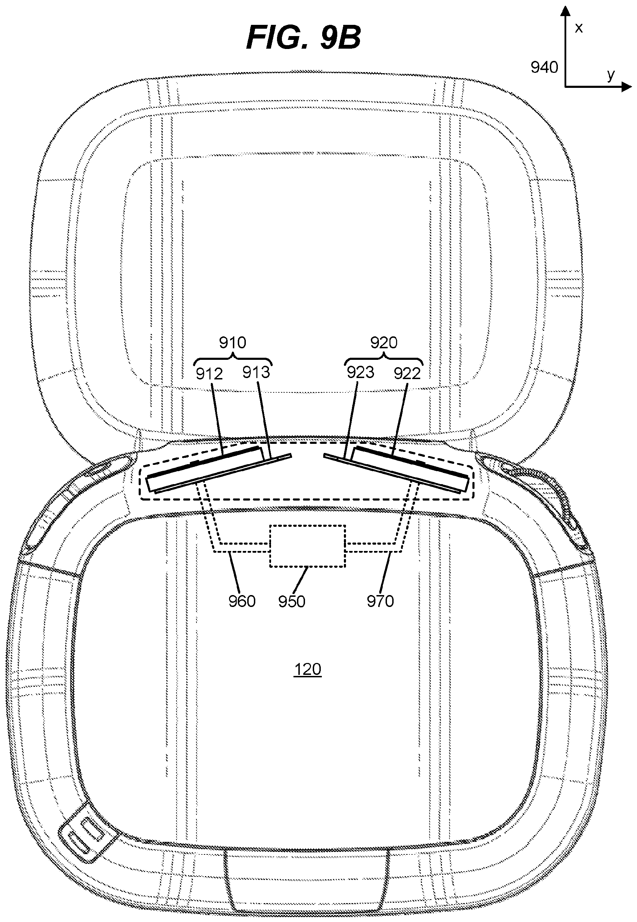

FIGS. 9A and 9B are cutaway illustrations of an example remote controller showing two antennas. The antenna system 575 of the remote controller 120 may include a first antenna 910, a second antenna 920, two feedlines 960, 970, and a transceiver 950 (the feedlines 960, 970 and transceiver 950 are illustrated in FIG. 9B, but not in FIG. 9A). The first antenna 910 and the second antenna 920 may be ceramic patch antennas, as depicted in FIGS. 9A and 9B, or may be any other type of directional antenna. The first antenna 910 may include a patch 911, a dielectric layer 912, a probe feed 913, and a ground plane 914. The patch 911, the dielectric layer 912, and the ground plane 914 may be mutually parallel. The patch 911 may couple to the dielectric layer 912, which may couple to the ground plane 914. A feedline 960 may couple to the ground plane 914. The feedline 960 also may couple to the probe feed 913 which passes through the dielectric layer 912 and couples to the patch 911. The feedline 960 may be coupled to a transceiver 950. The second antenna 920 may be a mirrored version of the first antenna 910 and includes the same components.

The feedline 960 may carry a signal from the transceiver 950 to the first antenna 910 when the antenna system 575 is transmitting a signal, and may carry a signal from the first antenna 910 to the transceiver 950 when the antenna system 575 is receiving a signal. The feedline 960 may be a transmission line, such as a coaxial cable. The tubular conducting shield of the coaxial cable may couple to the ground plane 914. The inner conductor of the coaxial cable may couple to the probe feed 913. In some embodiments, the inner conductor of the coaxial cable is the probe feed 913. In some embodiments, a matching circuit is coupled between the feedline 960 and the first antenna 910 for impedance matching.

The probe feed 913 may be a wire perpendicular to the dielectric layer 912 which couples electromagnetic energy in or out of the patch 911. The patch 911 may be a thin, rectangular conductor (e.g., metal). The probe feed 913 may couple to the patch 911 at a point that is centered along the short axis of the patch 911 and off-center along the long axis of the patch 911.

The dielectric layer 912 may separate the patch 911 from the ground plane 914. The dielectric layer 912 may be a ceramic substrate. The ground plane 914 may be a thin sheet of conductive material (e.g., metal).

In some embodiments, the first antenna 910 and the second antenna 920 are tilted away from the x-axis (along the x-y plane). FIG. 9B illustrates an embodiment in which the first antenna 910 is tilted 15° from the x-axis away from the y-axis and the second antenna 920 is tilted 15° from the y-axis towards the y-axis. This configuration may provide for path diversity.

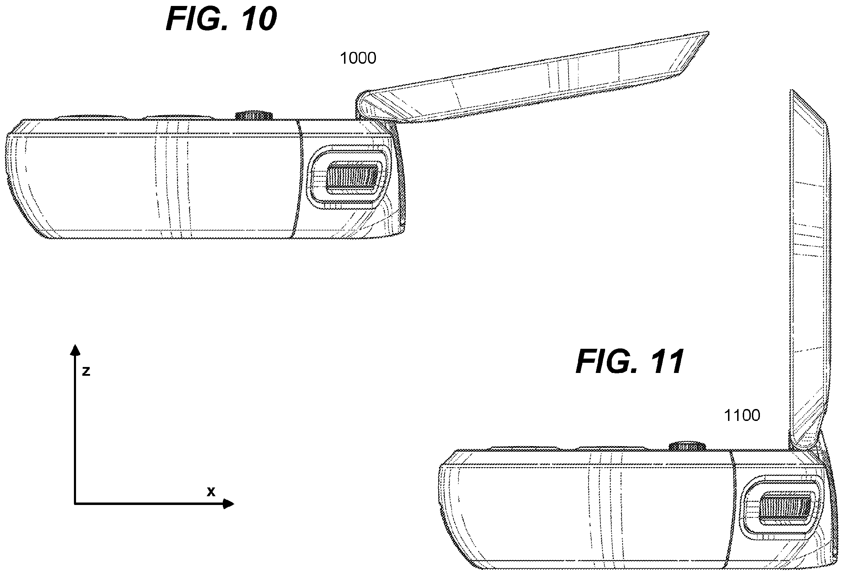

FIGS. 10 and 11 illustrate a remote controller 120 with the screen 170 rotated to a horizontal position and a vertical position, respectively, according to an embodiment. FIG. 10 illustrates the remote controller 120 with the second section 340 rotated 170° relative to the first section 330. Herein, this orientation is denoted as the horizontal position 1000 of the remote controller 120. In the horizontal position 1000, the screen 170 and the face of the first section 330 may be approximately parallel. The horizontal position 1000 may be within about 20° of the 170° orientation depicted in FIG. 10. FIG. 11 illustrates the second section 340 oriented at a 90° angle relative to the first section 330. Herein, this orientation is denoted as the vertical position 1100 of the remote controller 120. In the vertical position 1100, the screen 170 and the face of the first section 330 are approximately perpendicular. The vertical position 1100 may be within about 20° of the perpendicular orientation depicted in FIG. 11. The relative orientation of the first section 330 and the second section 340 of the remote controller 120 may affect the radiation pattern of the first antenna 910 and the second antenna 920 of the remote controller 120. In some embodiments, the screen 170 may be a screen includes a metal back. As illustrated below, the metal back of the screen 170 may contribute significantly to the radiation patterns of the antennas 910, 920.

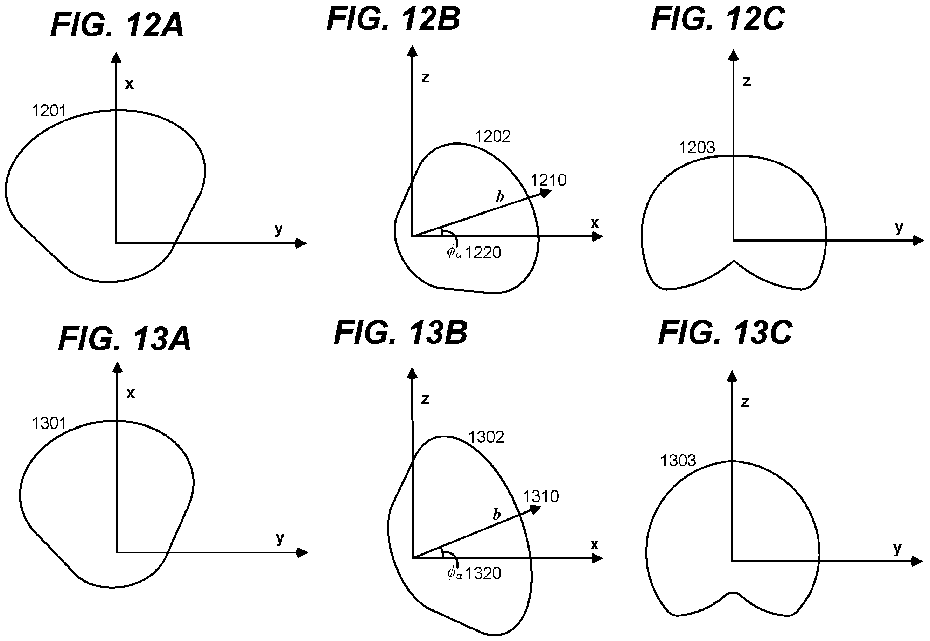

FIGS. 12A, 12B, and 12C illustrate a radiation pattern of an antenna of a remote controller when the display of the remote controller is rotated to a horizontal position, according to an embodiment. The radiation pattern may correspond to the first antenna 910 when the remote controller 120 is in the horizontal position 1000. FIGS. 12A, 12B, and 12C illustrate three cross-sections of the radiation pattern: a cross section 1200 with the x-y plane, a cross section 1201 with the x-z plane, and a cross section 1202 with the y-z plane. The cross section 1200 with the x-y plane illustrates that the radiation pattern of the first antenna 910 is tilted in the counterclockwise direction relative to the x-axis. This asymmetry is the result of the first antenna 910 being titled away from the x-axis, as illustrated in FIG. 9B. The radiation pattern of the second antenna 920 may be similarly tilted relative to the x-axis, albeit in the opposite direction.

FIG. 12B illustrates the radiation direction vector ***b*** 1210 for the antenna system 575. Unlike the radiation direction vector ***b*** 1210, the axes of maximum gain for the first and second antenna 910, 920 may be outside of the x-z plane. In FIG. 12B, the axes of maximum gain for the first and second antenna 910, 920 may be partially directed out of the page and into the page, respectively. The radiation vector ***b*** 1210 may be centered between these two axes of maximum gain.

FIGS. 13A, 13B, and 13C illustrate the radiation pattern of the first antenna 910 of a remote controller 120 when the screen 170 of the remote controller 120 is rotated to a vertical position 1100, according to an embodiment. The illustrated radiation pattern may correspond to the remote controller 120 as configured in FIG. 11. Changing the relative orientations of the first section 330 and the second section 340 of the remote controller 120 may affect the radiation pattern of the antennas 910, 920. When the remote controller 120 is in a vertical position 1100, the cross-section 1301 of the radiation pattern in the x-y plane may be thinner than the cross-section 1201 of the radiation pattern for the horizontal position 1000. In the x-z plane, the cross-section 1302 for the vertical position 1100 may extend further in the positive and negative z directions compared to the cross-section 1201 of the horizontal position 1100. Finally, in the z-y plane, the cross-section 1303 for the vertical position 1100 is taller in the z-direction but thinner in the y-direction compared to the cross-section 1303 of the horizontal position 1000. In some embodiments, the radiation pattern for the horizontal position 1000 may have a main lobe that is relatively similar to the wide main lobe 460 illustrated in FIG. 4D and the radiation pattern for the vertical position 1100 may have a main lobe that is relatively similar to the thin main lobe 450 illustrated in FIG. 4C.

Changing the relative orientations of the first section 330 and the second section 340 of the remote controller 120 also may affect the axes of maximum gain for the antennas 910, 920. Compared to horizontal position 1000, the axes of maximum gain for the vertical position 1100 may be higher (i.e., have a larger z-component) for both the first antenna 910 and second antenna 920. Accordingly, the radiation direction vector ***b*** 1310 for the vertical position 1100 may be directed higher as well. Thus, the angle *φ_{α}* 1320 that the radiation direction vector ***b*** 1310 makes with the horizontal (x-y) plane when in the remote controller 120 vertical position 1100 may be higher than the angle *φ_{α}* 1220 when in the remote controller 120 is in the horizontal position 1000.

In some embodiments, the remote controller 120 includes sensors which may detect the rotation of the hinge 350. The remote controller 120 may store a model of the radiation patterns for the antenna system 575 mapped to the orientation of the hinge 350. Based on the detected rotation of the hinge 350, the remote controller 120 may determine the radiation direction vector ***b*** 410, the arc threshold T*_{α}*, and/or the tilt up or tilt down thresholds *T*_{*β*1} and *T*_{*β*2}*.* Thus, the display of antenna direction indicator 730 of the user interface 700 may be based, in part, on the detected orientation of the hinge 350.

### ADDITIONAL CONSIDERATIONS

The disclosed configuration describes a system and method for displaying a user interface 700 on a remote controller 120 to assist a user in correctly orienting the remote controller 120 for optimal communication with an aerial vehicle 110. Position information may be received by the remote controller 120 from the aerial vehicle 110. The remote controller 120 may detect its own position and orientation. Based on the orientation of the remote controller 120 and the relative position of the remote controller 120 and the aerial vehicle 110, the remote controller 120 displays an indication to the user to assist the user in orienting the remote controller 120 so that one or more directional antennas of the remote controller 120 are oriented for a high transmit power.

By way of example, the remote controller 120 may include two antennas 910, 920. These antennas 910, 920 may be ceramic patch antennas. The antennas 910, 920 may be oriented 30° apart from each other for transmit diversity. The remote controller 120 may also include a screen 170 which is attached to the rest of the remote controller 120 with a hinge 350. The orientation of the screen 170 may affect the radiation pattern of the remote controller 120. The indication in the user interface 700 that assists the user in orienting the remote controller 120 may be based, in part, on the detected rotation of the hinge 350 to account for this effect on the radiation pattern.

Throughout this specification, plural instances may implement components, operations, or structures described as a single instance. Although individual operations of one or more methods are illustrated and described as separate operations, one or more of the individual operations may be performed concurrently, and nothing requires that the operations be performed in the order illustrated. Structures and functionality presented as separate components in example configurations may be implemented as a combined structure or component. Similarly, structures and functionality presented as a single component may be implemented as separate components. These and other variations, modifications, additions, and improvements fall within the scope of the subject matter herein.

Unless specifically stated otherwise, discussions herein using words such as "processing," "computing," "calculating," "determining," "presenting," "displaying," or the like may refer to actions or processes of a machine (e.g., a computer) that manipulates or transforms data represented as physical (e.g., electronic, magnetic, or optical) quantities within one or more memories (e.g., volatile memory, non-volatile memory, or a combination thereof), registers, or other machine components that receive, store, transmit, or display information.

As used herein any reference to "one embodiment" or "an embodiment" means that a particular element, feature, structure, or characteristic described in connection with the embodiment is included in at least one embodiment. The appearances of the phrase "in one embodiment" in various places in the specification are not necessarily all referring to the same embodiment.

Some embodiments may be described using the expression "coupled" and "connected" along with their derivatives. For example, some embodiments may be described using the term "coupled" to indicate that two or more elements are in direct physical or electrical contact. The term "coupled," however, may also mean that two or more elements are not in direct contact with each other, but yet still co-operate or interact with each other. The embodiments are not limited in this context.

As used herein, the terms "comprises," "comprising," "includes," "including," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of the "a" or "an" are employed to describe elements and components of the embodiments herein. This is done merely for convenience and to give a general sense of the invention. This description should be read to include one or at least one and the singular also includes the plural unless it is obvious that it is meant otherwise.

Upon reading this disclosure, those of skill in the art will appreciate still additional alternative structural and functional designs for the disclosed remote controller, the user interface thereof, and associated systems. Thus, while particular embodiments and applications have been illustrated and described, it is to be understood that the disclosed embodiments are not limited to the precise construction and components disclosed herein. Various modifications, changes and variations, which will be apparent to those skilled in the art, may be made in the arrangement, operation and details of the method and apparatus disclosed herein without departing from the scope defined in the appended claims.

## Claims

1. A method on a device (120) communicatively coupled with an aerial vehicle (110), the method comprising:
receiving, via one or more antennas of the device (120), position information for the aerial vehicle (110);
detecting a position of the device (110);
**characterised by**:
estimating a direction of a displacement between the aerial vehicle (110) and the device (120) based on the position information for the aerial vehicle (110) and the detected position of the device (120);
estimating a radiation direction based on an orientation of the device (120); and
providing for display, based on the direction of the displacement and the radiation direction, an indication to rotate the device (120) in a particular direction, wherein the indication to rotate the device (120) indicates a direction to rotate, the direction to rotate either clockwise or counterclockwise, responsive to determining that a difference between the radiation direction and the direction of the displacement between the aerial vehicle (110) and the device (120) is greater than a threshold value.

2. The method of claim 1, wherein estimating the radiation direction based on the orientation of the device (120) further comprises detecting the orientation of the device (120) with a magnetometer of the device.

3. The method of claim 1, wherein at least one of the one or more antennas receive video data transmitted from the aerial vehicle (110) and wherein at least one of the one or more antennas transmits control information to the aerial vehicle (110), the control information to control the movement of the aerial vehicle (110).

4. The method of claim 1, wherein detecting the position of the device (120) comprises detecting the position with a global positioning satellite, GPS, receiver of the device.

5. The method of claim 1, wherein the threshold value is based on a radiation pattern of at least one of the one or more antennas of the device (120).

6. The method of claim 1, wherein the threshold value is based on the displacement between the aerial vehicle (110) and the device (120).

7. The method of claim 1, wherein one or more antennas of the aerial vehicle (110) transmits the position information for the aerial vehicle (110), the one or more antennas of the aerial vehicle (110) having an omnidirectional radiation pattern.

8. The method of claim 1, wherein the one or more antennas of the device (120) include a patch antenna internal to the device (120).

9. The method of claim 1, wherein the radiation direction is based on a radiation pattern of an antenna of the one or more antennas.

10. The method of claim 1, wherein the position information for the aerial vehicle (110) includes altitude information detected with a barometer on the aerial vehicle (110).

11. A non-transitory computer-readable storage medium comprising stored instructions, wherein the instructions, when executed by at least one processors, cause the processor to:
receive, via one or more antennas of a device (120), position information for an aerial vehicle (110) communicatively coupled with the device (120);
detect a position of the device (120);
**characterised in that** the instructions further cause the processor to estimate a direction of a displacement between the aerial vehicle (110) and the device (120) based on the position information for the aerial vehicle (110) and the detected position of the device (120);
estimate a radiation direction based on an orientation of the device (120); and
provide for display, based on the direction of the displacement and the radiation direction, an indication to rotate the device in a particular direction, wherein the indication to rotate the device (120) comprises an indication of a direction to rotate, the direction to rotate either clockwise or counterclockwise, responsive to determining that a difference between the radiation direction and the direction of the displacement between the aerial vehicle (110) and the device (120) is greater than a threshold value.

12. A device (120) comprising:
one or more directional antennas, the one or more antennas configured to receive position information for an aerial vehicle (110);
a global positioning satellite, GPS, receiver configured to detect a position of the device;
a screen (170);
at least one processor;
a memory storing instructions, **characterised in that**: the instructions when executed by the processor, cause the processor to:
estimate a direction of a displacement between the aerial vehicle (110) and the device (120) based on the position information for the aerial vehicle (110) and the detected position of the device (120);
estimate a radiation direction based on an orientation of the device (120); and
provide for display on the screen (170), based on the direction of the displacement and the radiation direction, an indication to rotate the device (120) in a particular direction, wherein the indication to rotate the device (120) comprises an indication of a direction to rotate, the direction to rotate either clockwise or counterclockwise, responsive to determining that a difference between the radiation direction and the direction of the displacement between the aerial vehicle (110) and the device (120) is greater than a threshold value.

13. The device of claim 12, further comprising a magnetometer configured to detect the orientation of the device (120).

## Patentansprüche

1. Ein Verfahren auf einer Vorrichtung (120), die kommunikativ mit einem Luftfahrzeug (110) gekoppelt ist, wobei das Verfahren Folgendes umfasst:
Empfangen, über eine oder mehrere Antennen der Vorrichtung (120), von Positionsinformationen für das Luftfahrzeug (110);
Erkennen einer Position der Vorrichtung (110);
durch Folgendes gekennzeichnet:
Schätzen einer Richtung einer Verschiebung zwischen dem Luftfahrzeug (110) und der Vorrichtung (120) basierend auf den Positionsinformationen für das Luftfahrzeug (110) und der erkannten Position der Vorrichtung (120);
Schätzen einer Strahlungsrichtung basierend auf einer Ausrichtung der Vorrichtung (120); und
Bereitstellen zur Anzeige, basierend auf der Richtung der Verschiebung und der Strahlungsrichtung, einer Angabe zum Drehen der Vorrichtung (120) in eine bestimmte Richtung, wobei die Angabe zum Drehen der Vorrichtung (120) eine Richtung zum Drehen angibt, wobei die Richtung zum Drehen entweder im Uhrzeigersinn oder entgegen dem Uhrzeigersinn ist, infolge der Bestimmung, dass ein Unterschied zwischen der Strahlungsrichtung und der Richtung der Verschiebung zwischen dem Luftfahrzeug (110) und der Vorrichtung (120) einen Schwellenwert überschreitet.

2. Das Verfahren nach Anspruch 1, wobei das auf der Ausrichtung der Vorrichtung (120) basierende Schätzen der Strahlungsrichtung weiter das Erkennen der Ausrichtung der Vorrichtung (120) mit einem Magnetometer der Vorrichtung umfasst.

3. Das Verfahren nach Anspruch 1, wobei mindestens eine der einen oder der mehreren Antennen Videodaten empfängt, die von dem Luftfahrzeug (110) übermittelt werden, und wobei mindestens eine der einen oder der mehreren Antennen Steuerungsinformationen an das Luftfahrzeug (110) übermittelt, wobei die Steuerungsinformationen der Steuerung der Bewegung des Luftfahrzeugs (110) dienen.

4. Das Verfahren nach Anspruch 1, wobei das Erkennen der Position der Vorrichtung (120) das Erkennen der Position mit einem GPS-Empfänger (Global Positioning Satellite, Satellit zur globalen Positionsbestimmung) der Vorrichtung umfasst.

5. Das Verfahren nach Anspruch 1, wobei der Schwellenwert auf einem Strahlungsmuster von mindestens einer der einen oder der mehreren Antennen der Vorrichtung (120) basiert.

6. Das Verfahren nach Anspruch 1, wobei der Schwellenwert auf der Verschiebung zwischen dem Luftfahrzeug (110) und der Vorrichtung (120) basiert.

7. Das Verfahren nach Anspruch 1, wobei eine oder mehrere Antennen des Luftfahrzeugs (110) die Positionsinformationen für das Luftfahrzeug (110) übermitteln, wobei die eine oder die mehreren Antennen des Luftfahrzeugs (110) ein omnidirektionales Strahlungsmuster aufweisen.

8. Das Verfahren nach Anspruch 1, wobei die eine oder die mehreren Antennen der Vorrichtung (120) eine Patchantenne enthalten, die sich innerhalb der Vorrichtung (120) befindet.

9. Das Verfahren nach Anspruch 1, wobei die Strahlungsrichtung auf einem Strahlungsmuster von einer Antenne der einen oder der mehreren Antennen basiert.

10. Das Verfahren nach Anspruch 1, wobei die Positionsinformationen für das Luftfahrzeug (110) Höheninformationen enthalten, die mit einem Barometer auf dem Luftfahrzeug (110) erkannt werden.

11. Ein nicht vorübergehendes computerlesbares Speichermedium umfassend gespeicherte Anweisungen, wobei die Anweisungen bei Ausführung durch mindestens eine Verarbeitungseinheit veranlassen, dass die Verarbeitungseinheit:
über eine oder mehrere Antennen einer Vorrichtung (120) Positionsinformationen für ein kommunikativ mit der Vorrichtung (120) gekoppeltes Luftfahrzeug (110) empfängt;
eine Position der Vorrichtung (120) erkennt;
**dadurch gekennzeichnet, dass** die Anweisungen weiter veranlassen, dass die Verarbeitungseinheit basierend auf den Positionsinformationen für das Luftfahrzeug (110) und der erkannten Position der Vorrichtung (120) eine Richtung einer Verschiebung zwischen dem Luftfahrzeug (110) und der Vorrichtung (120) schätzt;
basierend auf einer Ausrichtung der Vorrichtung (120) eine Strahlungsrichtung schätzt; und
basierend auf der Richtung der Verschiebung und der Strahlungsrichtung eine Angabe zum Drehen der Vorrichtung in eine bestimmte Richtung zur Anzeige bereitstellt, wobei die Angabe zum Drehen der Vorrichtung (120) eine Angabe einer Richtung zum Drehen umfasst, wobei die Richtung zum Drehen entweder im Uhrzeigersinn oder entgegen dem Uhrzeigersinn ist, infolge der Bestimmung, dass ein Unterschied zwischen der Strahlungsrichtung und der Richtung der Verschiebung zwischen dem Luftfahrzeug (110) und der Vorrichtung (120) einen Schwellenwert überschreitet.

12. Eine Vorrichtung (120), umfassend:
eine oder mehrere Richtantennen, wobei die eine oder die mehreren Antennen so konfiguriert sind, dass Positionsinformationen für ein Luftfahrzeug (110) empfangen werden;
einen GPS-Empfänger (Global Positioning Satellite, Satellit zur globalen Positionsbestimmung), so konfiguriert, dass eine Position der Vorrichtung erkannt wird;
einen Bildschirm (170);
mindestens eine Verarbeitungseinheit;
einen Speicher mit darauf gespeicherten Anweisungen, **dadurch gekennzeichnet, dass**:
die Anweisungen bei Ausführung durch die Verarbeitungseinheit veranlassen, dass die Verarbeitungseinheit:
basierend auf den Positionsinformationen für das Luftfahrzeug (110) und der erkannten Position der Vorrichtung (120) eine Richtung einer Verschiebung zwischen dem Luftfahrzeug (110) und der Vorrichtung (120) schätzt;
basierend auf einer Ausrichtung der Vorrichtung (120) eine Strahlungsrichtung schätzt; und
basierend auf der Richtung der Verschiebung und der Strahlungsrichtung eine Angabe zum Drehen der Vorrichtung (120) in eine bestimmte Richtung zur Anzeige auf dem Bildschirm (170) bereitstellt, wobei die Angabe zum Drehen der Vorrichtung (120) eine Angabe einer Richtung zum Drehen umfasst, wobei die Richtung zum Drehen entweder im Uhrzeigersinn oder entgegen dem Uhrzeigersinn ist, infolge der Bestimmung, dass ein Unterschied zwischen der Strahlungsrichtung und der Richtung der Verschiebung zwischen dem Luftfahrzeug (110) und der Vorrichtung (120) einen Schwellenwert überschreitet.

13. Die Vorrichtung nach Anspruch 12, weiter umfassend ein Magnetometer, so konfiguriert, dass die Ausrichtung der Vorrichtung (120) erkannt wird.

## Revendications

1. Un procédé sur un dispositif (120) couplé en communication à un véhicule aérien (110), le procédé comprenant :
la réception, par l'intermédiaire d'une ou de plusieurs antennes du dispositif (120), d'informations de position pour le véhicule aérien (110),
la détection d'une position du dispositif (110),
**caractérisé par** :
l'estimation d'une direction d'un déplacement entre le véhicule aérien (110) et le dispositif (120) en fonction des informations de position pour le véhicule aérien (110) et de la position détectée du dispositif (120),
l'estimation d'une direction de rayonnement en fonction d'une orientation du dispositif (120), et
la fourniture à des fins d'affichage, en fonction de la direction du déplacement et de la direction de rayonnement, d'une indication de pivotement du dispositif (120) dans une direction particulière, où l'indication de pivotement du dispositif (120) indique une direction de pivotement, la direction de pivotement étant soit dans le sens des aiguilles d'une montre ou dans le sens contraire des aiguilles d'une montre, en réponse à la détermination qu'une différence entre la direction de rayonnement et la direction du déplacement entre le véhicule aérien (110) et le dispositif (120) est supérieure à une valeur seuil.

2. Le procédé selon la Revendication 1, où l'estimation de la direction de rayonnement en fonction de l'orientation du dispositif (120) comprend en outre la détection de l'orientation du dispositif (120) avec un magnétomètre du dispositif.

3. Le procédé selon la Revendication 1, où au moins une des une ou plusieurs antennes reçoit des données vidéo transmises à partir du véhicule aérien (110) et où au moins une des une ou plusieurs antennes transmet des informations de commande au véhicule aérien (110), les informations de commande étant destinées à commander le déplacement du véhicule aérien (110).

4. Le procédé selon la Revendication 1, où la détection de la position du dispositif (120) comprend la détection de la position avec un récepteur de système de géopositionnement par satellite, GPS, du dispositif.

5. Le procédé selon la Revendication 1, où la valeur seuil est basée sur un diagramme de rayonnement d'au moins une des une ou plusieurs antennes du dispositif (120).

6. Le procédé selon la Revendication 1, où la valeur seuil est basée sur le déplacement entre le véhicule aérien (110) et le dispositif (120).

7. Le procédé selon la Revendication 1, où une ou plusieurs antennes du véhicule aérien (110) transmettent les informations de position pour le véhicule aérien (110), les une ou plusieurs antennes du véhicule aérien (110) possédant un diagramme de rayonnement omnidirectionnel.

8. Le procédé selon la Revendication 1, où les une ou plusieurs antennes du dispositif (120) comprennent une antenne à plaque interne au dispositif (120).

9. Le procédé selon la Revendication 1, où la direction de rayonnement est basée sur un diagramme de rayonnement d'une antenne des une ou plusieurs antennes.

10. Le procédé selon la Revendication 1, où les informations de position pour le véhicule aérien (110) comprennent des informations d'altitude détectées avec un baromètre sur le véhicule aérien (110).

11. Un support à mémoire lisible par ordinateur non transitoire contenant des instructions conservées en mémoire, où les instructions, lorsqu'elles sont exécutées par au moins un processeur, amènent le processeur à :
recevoir, par l'intermédiaire d'une ou de plusieurs antennes d'un dispositif (120), des informations de position pour un véhicule aérien (110) couplé en communication au dispositif (120),
détecter une position du dispositif (120),
**caractérisé en ce que** les instructions amènent en outre le processeur à estimer une direction d'un déplacement entre le véhicule aérien (110) et le dispositif (120) en fonction des informations de position pour le véhicule aérien (110) et de la position détectée du dispositif (120),
estimer une direction de rayonnement en fonction d'une orientation du dispositif (120), et
fournir à des fins d'affichage, en fonction de la direction du déplacement et de la direction de rayonnement, une indication de pivotement du dispositif dans une direction particulière, où l'indication de pivotement du dispositif (120) comprend une indication d'une direction de pivotement, la direction de pivotement étant soit dans le sens des aiguilles d'une montre ou dans le sens contraire des aiguilles d'une montre, en réponse à la détermination qu'une différence entre la direction de rayonnement et la direction du déplacement entre le véhicule aérien (110) et le dispositif (120) est supérieure à une valeur seuil.

12. Un dispositif (120) comprenant :
une ou plusieurs antennes directionnelles, les une ou plusieurs antennes étant configurées de façon à recevoir des informations de position pour un véhicule aérien (110),
un récepteur de système de géopositionnement par satellite, GPS, configuré de façon à détecter une position du dispositif,
un écran (170),
au moins un processeur,
une mémoire conservant en mémoire des instructions, **caractérisée en ce que** :
les instructions, lorsqu'elles sont exécutées par le processeur, amènent le processeur à :
estimer une direction d'un déplacement entre le véhicule aérien (110) et le dispositif (120) en fonction des informations de position pour le véhicule aérien (110) et de la position détectée du dispositif (120),
estimer une direction de rayonnement en fonction d'une orientation du dispositif (120), et
fournir à des fins d'affichage sur l'écran (170), en fonction de la direction du déplacement et de la direction de rayonnement, une indication de pivotement du dispositif (120) dans une direction particulière, où l'indication de pivotement du dispositif (120) comprend une indication d'une direction de pivotement, la direction de pivotement étant soit dans le sens des aiguilles d'une montre ou dans le sens contraire des aiguilles d'une montre, en réponse à la détermination qu'une différence entre la direction de rayonnement et la direction du déplacement entre le véhicule aérien (110) et le dispositif (120) est supérieure à une valeur seuil.

13. Le dispositif selon la Revendication 12, comprenant en outre un magnétomètre configuré de façon à détecter l'orientation du dispositif (120).
